# EUROPÄISCHE PATENTSCHRIFT

(11) **EP 0 716 161 B1**
(45) Veröffentlichungstag und Bekanntmachung des Hinweises auf die Patenterteilung: **31.05.2000**
(21) Anmeldenummer: 95117899.5
(22) Anmeldetag: 14.11.1995
(51) Int. Cl.: C23C 14/34, H01J 37/34

(54) **Verfahren und Einrichtung zur Beschichtung optischer Substrate durch Zerstäubung**
Method and apparatus for coating of optical substrates by sputtering
Procédé et dispositif pour le revêtement de substrats optiques par pulvérisation

(30) Priorität: 05.12.1994 CH 367594
(43) Veröffentlichungstag der Anmeldung: 12.06.1996
(73) Patentinhaber: Satis Vacuum Industries AG, 8700 Küsnacht (CH)
(72) Erfinder: Suter, Rudolf, CH-6048 Horw (CH)
(74) Vertreter: Petschner, Goetz

(56) Entgegenhaltungen:
- PATENT ABSTRACTS OF JAPAN vol. 010 no. 287 (C-375) ,30.September 1986 & JP-A-61 104071 (MATSUSHITA ELECTRIC IND CO LTD) 22.Mai 1986,
- PATENT ABSTRACTS OF JAPAN vol. 014 no. 106 (C-0694) ,27.Februar 1990 & JP-A-01 309965 (MATSUSHITA ELECTRIC IND CO LTD) 14.Dezember 1989,
- JOURNAL OF VACUUM SCIENCE & TECHNOLOGY A (VACUUM, SURFACES, AND FILMS), JAN.-FEB. 1993, USA, Bd. 11, Nr. 1, ISSN 0734-2101, Seiten 267-270, AUCIELLO O ET AL 'New rotating target holder for laser ablation and ion beam sputter deposition of multicomponent and multilayered thin films'
- PATENT ABSTRACTS OF JAPAN vol. 017 no. 247 (C-1059) ,18.Mai 1993 & JP-A-04 371577 (SONY CORP) 24.Dezember 1992,
- PATENT ABSTRACTS OF JAPAN vol. 011 no. 185 (C-428) ,13.Juni 1987 & JP-A-62 007851 (HITACHI LTD) 14.Januar 1987,

## Beschreibung

Die vorliegende Erfindung betrifft ein Verfahren zum Beschichten optischer Substrate, insbesondere zum Beschichten von Brillengläser oder Linsen mit reversiblen photochromischen Eigenschaften, wobei in einem gasdicht verschliessbaren, evakuierbaren und mit einer Atmosphäre aus inertem Gas versehbaren Rezipienten unterhalb oder oberhalb eines mit einer Welle oder Achse umlaufenden Trägers für die zu beschichtenden optischen Substrate und distanziert von diesem wenigstens zwei Sputter-Quellen angeordnet sind.

Aus der CH-A-662 188 sowie durch die Literaturstellen PATENT ABSTRACTS OF JAPAN vol.10 no.287 (C-375) 30-09-86; JPA61104071 und PATENT ABSTRACTS OF JAPAN vol.14 no.106 (C-0694) 27-02-90; JP-A-1309965 sowie JOURNAL OF VACUUM SCIENCE & TECHNOLOGY A (VACUUM, SURFACES, AND FILMS), JAN.-FEB. 1993, USA, Bd.11, Nr.1, ISSN 0734-2101, Seiten 267-270, AUCIELLO O ET AL "New rotating target holder for laser ablation and ion beam sputter deposition of multicomponent and multilayered thin films" sind bereits solche Verfahren zum Beschichten optischer Substrate, insbesondere zum Beschichten von Brillengläser oder Linsen mit reversiblen photochromischen Eigenschaften bekannt geworden, wobei aus der letzt genannten Literaturstelle auch eine Sputter-Quelle mit oszillierender Bewegung hervorgeht, wobei Sputtertargets geneigt an ihrer Halterung angeordnet sind.

Mit diesen bekannten Verfahren und Anordnungen ist es bisher aber nicht gelungen, eine ausreichende Uniformität der Beschichtung zu erreichen.

Gemäss vorliegender Erfindung lässt sich nun eine **praktisch absolute Gleichmässigkeit** der auf dem Substrat aufgebrachten Beschichtung dadurch erreichen, dass den Sputter-Quellen je über eine Halterung eine Taumelbewegung erteilt wird, wobei die Taumelbewegungen der beiden Sputter-Quellen gegenläufig sind.

Zur Durchführung des vorgenannten Verfahrens ist nun eine Beschichtungseinrichtung vorgesehen, die sich erfindungsgemäss dadurch auszeichnet, dass jede Sputter-Quelle in einer neigbar und ggf. drehbar abgestützten Halterung angeordnet ist, an der zur Erzeugung einer gegenläufigen Taumelbewegung exzentrisch umlaufende Getriebemittel angreifen, wobei jede Halterung als eine glockenförmige Fassung mit zentrischer Achse ausgebildet und in einer kugelartigen Pfanne an einem Gehäuseteil abgestützt ist.

Hierbei besteht eine vorteilhafte Ausgestaltung darin, dass das freie Ende der zentrischen Achse jeder Halterung innerhalb eines Freiraumes eines Gehäuseteils über Pendelrollenlagermittel in eine erste Exzenterhülse eingreift, die über Lagermittel in einer zweiten, am Gehäuseteil über Lagermittel drehbar abgestützten Exzenterhülse umlaufend geführt ist, wobei diese beiden Exzenterhülsen über koaxiale Antriebsachsen und Zahnkränze mit Motor- und Getriebemitteln in Antriebsverbindung stehen.

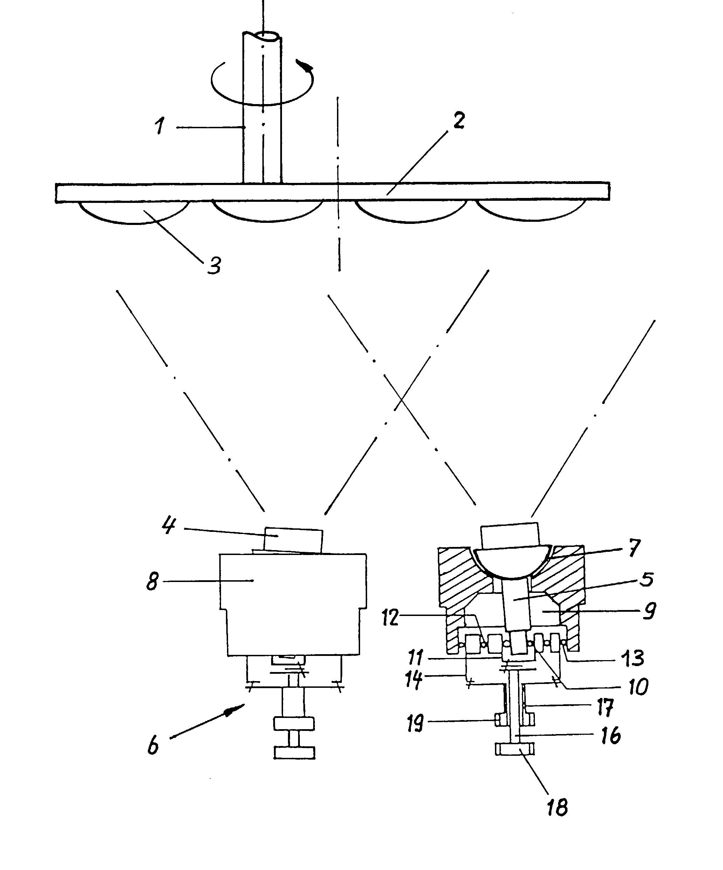

Eine beispielsweise Ausführungsform des Erfindungsgegenstandes ist nachfolgend anhand der Zeichnung, welche in schematischer Teildarstellung eine Einrichtung zur Beschichtung optischer Substrate, insbesondere zur Beschichtung von Brillengläsern oder Linsen zeigt, näher erläutert.

Die Einrichtung zur Beschichtung optischer Substrate, insbesondere zur Beschichtung von Brillengläsern oder Linsen mit reversiblen photochromischen Eigenschaften, umfasst einen nicht näher gezeigten gasdicht verschliessbaren, evakuierbaren und mit einer Atmosphäre aus inertem Gas versehbaren Rezipienten. In diesem befindet sich hier unterhalb eines mit einer motorisch antreibbaren (nicht gezeigt) Welle 1 umlaufenden Trägers 2 für die zu beschichtenden optischen Substrate 3 und distanziert von diesem Träger zwei Sputter-Quellen 4.

Soweit ist eine solche Einrichtung bekannt.

Erfindungswesentlich ist hier nun, dass die Sputter-Quellen 4 je an einer eine Taumelbewegung ausführenden Halterung 5 auswechselbar angeordnet sind, welche Taumelbewegungen dann vorzugsweise gegenläufig sein können. Diese Halterungen 5 sind hierfür drehbar und neigbar abgestützt, wobei an diesen zur Erzeugung der Taumelbewegung je exzentrisch umlaufende Getriebemittel 6 angreifen, wie das nachfolgend noch näher erläutert ist. Ferner wird die absolut gleichmässige Beschichtung noch dadurch unterstützt, dass der Träger 2 auf seiner Welle 1 exzentrisch aufsitzt.

Bei der hier gezeigten Ausführungsform einer solchen Anordnung ist nun jede Halterung 5 als eine glockenförmige Fassung mit zentrischer Achse ausgebildet und in einer kugelartigen Pfanne 7 an einem Gehäuseteil 8 derart abgestützt, dass durch eine entsprechende Verschiebung der glockenförmigen Fassung in der kugelartigen Pfanne den von den Halterungen 5 getragenen Sputter-Quellen 4 die vorstehend beschriebenen Taumelbewegungen erteilt werden können.

Hierfür kann die zentrische Achse der Halterung 5 innerhalb eines Freiraumes 9 des Gehäuseteils 8 eine pendelnde Bewegung ausführen. Zur Erzeugung der vorerwähnten Bewegungen greift das freie Ende der zentrischen Achse über geeignete Pendelrollenlagermittel 10 in eine erste Exzenterhülse 11 ein, die über Lagermittel 12 in einer zweiten, am Gehäuseteil 8 über Lagermittel 13 drehbar abgestützten Exzenterhülse 14 umlaufend geführt ist. Um diese beiden Exzenterhülsen 11 und 14 in der einleitend beschriebenen Weise antreiben zu können, stehen diese hier über koaxiale Antriebsachsen 16 und 17 und Zahnkränze 18 und 19 mit nicht näher gezeigten Motor- und Getriebemitteln in Antriebsverbindung.

Eine solche Anordnung erlaubt nicht nur einen gegenläufigen Antrieb der beiden Halterungen 5 und damit der beiden Sputter-Quellen 4, sondern es können an jeder Halterung 5 verschiedene Bewegungsarten über entsprechende Schaltgetriebe eingestellt werden, wie Spiralbewegung, Mehrblatt-Kurvenbewegung, Kreisbewegung u. a., sodass für jede Beschichtungsart und Geometrie der Substrate individuelle Strahlungsbahnen wählbar sind.

Selbstverständlich sind an einer solchen Einrichtung Modifikationen möglich, ohne dabei den Erfindungsgedanken zu verlassen.lnsbesondere kann eine solche Anordnung weniger oder mehr Sputter-Quellen und /oder auch Elektronenstrahlkanonen umfassen, wie das im genannten CH-Patent Nr. 662 188 beschrieben ist.

## Patentansprüche

1. Verfahren zum Beschichten optischer Substrate, insbesondere zum Beschichten von Brillengläser oder Linsen mit reversiblen photochromischen Eigenschaften, wobei in einem gasdicht verschliessbaren, evakuierbaren und mit einer Atmosphäre aus inertem Gas versehbaren Rezipienten unterhalb oder oberhalb eines mit einer Welle oder Achse umlaufenden Trägers für die zu beschichtenden optischen Substrate und distanziert von diesem wenigstens zwei Sputter-Quellen angeordnet sind,
dadurch gekennzeichnet,
dass den Sputter-Quellen (4) je über eine Halterung (5) eine Taumelbewegung erteilt wird, wobei die Taumelbewegungen der beiden Sputter-Quellen gegenläufig sind.

2. Beschichtungseinrichtung zur Durchführung des Verfahrens nach Anspruch 1,
wobei
jede Sputter-Quelle (4) in einer neigbar und ggf. drehbar abgestützten Halterung (5) angeordnet ist, an der zur Erzeugung einer gegenläufigen Taumelbewegung exzentrisch umlaufende Getriebemittel (6) angreifen, und jede Halterung (5) als eine glockenförmige Fassung mit zentrischer Achse ausgebildet und in einer kugelartigen Pfanne (7) an einem Gehäuseteil (8) abgestützt ist.

3. Beschichtungseinrichtung nach Anspruch 2, dadurch gekennzeichnet, dass das freie Ende der zentrischen Achse jeder Halterung (5) innerhalb eines Freiraumes (9) eines Gehäuseteils (8) über Pendelrollenlagermittel (10) in eine erste Exzenterhülse (11) eingreift, die über Lagermittel (12) in einer zweiten, am Gehäuseteil (8) über Lagermittel (13) drehbar abgestützten Exzenterhülse (14) umlaufend geführt ist, wobei diese beiden Exzenterhülsen (11 und 14) über koaxiale Antriebsachsen (16 und 17) und Zahnkränze (18 und 19) mit Motor- und Getriebemitteln in Antriebsverbindung stehen.

## Claims

1. Method of coating optical substrates, especially for the coating of spectacle glasses or lenses with reversible photochromatic properties, wherein at least two sputter sources are arranged in a container, which can be closed to be gas-tight, evacuated and provided with an atmosphere of inert gas, to be below or above a support, which rotates by a shaft or axle, for the optical substrates to be coated and at a spacing from this, characterised in that a tumbling movement is imparted to each of the sputter sources (4) by way of a respective holder (5), wherein the tumbling movements of the two sputter sources are in opposite sense.

2. Coating equipment for carrying out the method according to claim 1, wherein each sputter source (4) is arranged in an inclinably and in a given case rotatably supported holder (5), at which engage gear means (6) rotating eccentrically for generation of a tumbling movement of opposite sense, and each holder (5) is constructed as a bell-shaped mount with a central axle and is supported in a ball-like pan (7) at a housing part (8).

3. Coating equipment according to claim 2, characterised in that the free end of the central axle of each holder (5) engages in a first eccentric sleeve (11) within a free space (9) of a housing part (8) by way of pendulating roller bearing means (10), which sleeve is rotatably guided by way of bearing means (12) in a second eccentric sleeve (14) rotatably supported at the housing part (8) by way of bearing means (13), wherein these two eccentric sleeves (11 and 14) stand in drive connection with motor means and gear means by way of coaxial drive axles (16 and 17) and gear rims (18 and 19).

## Revendications

1. Procédé pour le revêtement de substrats optiques, notamment pour le revêtement de verres de lunettes ou de lentilles avec des caractéristiques photosensibles réversibles, où sont disposés dans un récipient pouvant être fermé d'une manière étanche aux gaz, pouvant être évacué et pouvant être pourvu d'une atmosphère de gaz inerte, en dessous ou au-dessus d'un support tournant avec un arbre ou axe pour les substrats optiques à revêtir et à distance de celui-ci, au moins deux sources de pulvérisation, caractérisé en ce que les sources de pulvérisation (4) sont soumises respectivement par un logement (5) à une nutation, où les nutations des deux sources de pulvérisation sont en sens contraire.

2. Dispositif de revêtement pour la mise en oeuvre du procédé selon la revendication 1, où chaque source de pulvérisation (4) est disposée dans un logement (5) supporté d'une manière inclinable et le cas échéant tournante, auquel s'appliquent, pour produire une nutation contraire, des moyens de transmission tournant excentriquement (6), et où chaque logement (5) est réalisé comme monture en forme de cloche avec un axe central et est supporté dans une cuvette en forme de bille (7) à la partie de boîtier (8).

3. Dispositif de revêtement selon la revendication 2, caractérisé en ce que l'extrémité libre de l'axe central de chaque logement (5) s'engage à l'intérieur d'un espace libre (9) d'une partie de boîtier (8) par des moyens de palier de roulement pendulaires (10) dans une première douille d'exentrique (11) qui est guidée d'une manière tournante par des moyens de palier (12) dans une deuxième douille d'éxentrique (14) supportée d'une manière rotative à la partie de boîtier (8) par des moyens de palier (13), où ces deux douilles d'exentrique (11 et 14) sont en liaison d'entraînement par des axes d'entraînement coaxiaux (16 et 17) et des couronnes dentées (18 et 19) avec des moyens de moteur et de transmission.
